# EUROPÄISCHE PATENTANMELDUNG

(11) **EP 1 146 571 A1**
(43) Veröffentlichungstag der Anmeldung: **17.10.2001**
(21) Anmeldenummer: 00108251.0
(22) Anmeldetag: 14.04.2000
(51) Int. Cl.: H01L 33/00

(54) **Lichtemittierendes Halbleiterbauelement und Verfahren zu seiner Herstellung**

(71) Anmelder: Infineon Technologies AG, 81669 München (DE)
(72) Erfinder: Althaus, Hans-Ludwig, 93138 Lappersdorf (DE); Gramann, Wolfgang, 93053 Regenburg (DE); Essl, Hans-Christian, 93186 Pettendorf (DE); Hurt, Hans, 93049 Regensburg (DE); Gattinger, Peter, 93049 Regensburg (DE); Reill, Joachim, 93197 Zeitlarn (DE); Krug, Joachim, 85080 Gaimersheim (DE); Wicke, Markus, 93138 Zappersdorf (DE); Kuhn, Gerhard, 93096 Käfering (DE); Wittl, Josef, 92331 Parsberg (DE); Weigert, Martin, 93152 Hardt (DE)
(74) Vertreter: Müller, Wolfram Hubertus, Dipl.-Phys.

(57) **Zusammenfassung**

Die Erfindung betrifft ein lichtemittierendes Halbleiterbauelement (1) mit einem lichterzeugenden oder empfangenden aktiven Halbleiterelement (2), bei dem das auszusendende oder zu empfangende Lichtbündel durch eine Lichtwegkorrektureinrichtung (41) geformt ist, wobei das aktive Halbleiterelement auf der Montage-Oberfläche (31) eines dasselbe abstützenden Trägerelements (3) befestigt ist, wobei das Trägerelement (3) aus einem kristallinen Material besteht und die Lichtwegkorrektureinrichtung (41) durch Oberflächen (32) des Trägerelements (3) selbst gebildet ist. Ferner betrifft die Erfindung ein Verfahren zur Herstellung eines lichtemittierenden Bauelemente (1) mit einem aktiven Halbleiterelement und einer Lichtwegkorrektureinrichtung (41).

## Beschreibung

Die Erfindung bezieht sich auf ein lichtemittierendes Halbleiterbauelement mit einem lichterzeugenden oder empfangenden aktiven Halbleiterelement, bei dem das auszusendende oder zu empfangende Lichtbündel durch eine Lichtwegkorrektureinrichtung geformt ist, wobei das aktive Halbleiterelement auf der Montage-Oberfläche eines dasselbe abstützenden Trägerelements befestigt ist

Lichtemittierende Halbleiterbauelemente, insbesondere Leuchtdioden, beinhalten meistens aktive lichtaussendende Halbleiterelemente, die das Licht in einem großen Raumwinkel oder sogar seitlich oder an der Kante emittieren. Für viele Anwendungen jedoch ist eine gerichtete Abstrahlung des emittierten Lichts in einen kleinen Raumwinkel bzw. in eine Richtung erwünscht. Dies ist insbesondere bei Sendern für die optische Datenübertragung wünschenswert.

Zur Bündelung der Lichtstrahlen kommen Reflektoren zum Einsatz, die das seitlich oder in einem großen Raumwinkel emittierte Licht in eine Hauptabstrahlrichtung bündeln. Bisher wurden solche Reflektoren durch das das Halbleiterelement tragende und diesem den Strom zuführende sogenannte Leadframe gebildet. Die Reflektorflächen werden durch entsprechend gebogene und geformte Ausläufer und Flächen der metallenen Leadframe-Teile gebildet. Nachteilig war hierbei die schlechte Qualität der spiegelnden Oberflächen (Rauheit, Reflektionsgrad), die daher groß genug hergestellt werden mussten und somit die Größe des lichtemittierenden Halbleiterbauelements nur bis zu einer gewissen Grenze minimierbar machten. Weiterhin nachteilig ist, dass bei direkter Befestigung des lichtemittierenden Halbleiterelements auf einem metallenen Leadframe die Dauerhaftigkeit der Verbindung durch die unterschiedlichen Wärmeausdehnungseigenschaften des Halbleitermaterials gegenüber dem Metall in seiner Lebensdauer beschränkt, beziehungsweise aufwendige Verbindungstechniken notwendig sind.

Aufgabe der Erfindung ist es, eine lichtemittierendes Halbleiterbauelement und ein Verfahren zu seiner Herstellung zur Verfügung zu stellen, bei dem der das lichtemittierende Halbleiterbauelement tragende Träger eine Lichtwegkorrektureinrichtung umfasst und die oben genannten Nachteile überwindet.

Diese Aufgabe wird durch ein lichtemittierendes Halbleiterbauelement nach Anspruch 1 und ein Verfahren zu seiner Herstellung nach Anspruch 9 gelöst.

Erfindungsgemäß besteht das Trägerelement aus einem kristallinen Material und die Lichtwegkorrektureinrichtung ist selbst durch Oberflächen des Trägerelements gebildet.

Die Erfindung schlägt vor, als Trägerelement nicht wie bisher Metall sondern ein kristallines Material vorzusehen, dessen Oberflächen so bearbeitet sind, dass sie zum Einen das aktive Halbleiterelement tragen und zum Anderen die Lichtwegkorrektureinrichtung zur Bündelung des emittierten beziehungsweise empfangenden Lichts bilden. Hierdurch kann die Oberfläche der spiegelnden Flächen wesentlich exakter hergestellt werden, was die Güte und den Reflektionsgrad erhöht, wodurch die reflektierenden Flächen näher mit kleinerer Oberfläche am lichtemittierenden oder empfangenden Halbleiterelement angeordnet werden kann. Hierdurch ist das Halbleiterbauelement kleiner ausführbar.

Vorteilhafterweise weist das Trägerelement eine Vertiefung auf, deren untere Begrenzungsfläche die Montageoberfläche bildet, auf der das aktive Halbleiterelement befestigt wird. Hierdurch ist durch die tiefer gesetzte Montage des aktiven Halbleiterelements ein niedrigerer Verguss des Bauteils möglich, da das aktive Halbleiterelement nicht mehr auf einer glatten Oberfläche sondern in einer dieses aufnehmenden Vertiefung befestigt ist. Hierdurch wird ebenfalls die Lichtausbeute erhöht, da weniger Material durchstrahlt werden muss.

Gemäß einer besonders bevorzugten Ausgestaltung der Erfindung weist das Trägerelement eine Vertiefung auf, dessen seitliche Begrenzungsflächen die Lichtwegkorrektureinrichtung bilden.

Eine besonders vorteilhafte und daher bevorzugte Ausgestaltung der Erfindung sieht vor, dass die die Lichtwegkorrektureinrichtung bildenden Oberflächen des Trägerelements mit einer Reflektionsschicht überzogen sind. Hierdurch wird die Reflexivität der Oberflächen weiter erhöht.

Vorteilhaft ist die Reflektionsschicht durch eine Metall-Schicht oder durch eine dielektrische Schichtfolge ausgebildet. Hierdurch ist in besonders einfacher Weise eine hochreflexive Schicht ermöglicht. Dem folgend kann zwischen der Oberfläche des Trägerelements und der Reflektionsschicht eine Isolationsschicht ausgebildet sein. Hierdurch kann eine Isolation zwischen einer leitenden metallenen Reflektionsschicht und dem Trägerelement mit einfachen und billigen Prozess-Schritten gewährleistet werden. Im Falle, dass eine reflektierende dielektrische Schicht zum Einsatz kommt, kann diese von Vorteil elektrisch isolierend ausgeführt sein.

Vorteilhafterweise bildet die metallene Reflektionsschicht eine der Stromzuführungen zum Licht erzeugenden oder empfangenden aktiven Halbleiterelement. Im Falle das eine dielektrische Schicht zur Reflektion vorgesehen ist, kann die stromzuführende Metallschicht unter der reflektierenden Schicht und/oder im Material der Lichtwegkorrektureinrichtung oder des Trägerelements und/oder in geeignet breiten Streifen über der Reflektionsoberfläche geführt sein.

Das erfindungsgemäße Verfahren zur Herstellung eines lichtemittierenden Bauelements mit einem aktiven Halbleiterelement und einer Lichtwegkorrektureinrichtung sieht vor, dass die die Lichtwegkorrektureinrichtung für das emittierte bzw. zu empfangende Licht eines aktiven Halbleiterelement bildenden Oberflächen in ein kristallines Material, insbesondere in den das aktiven Halbleiterelements tragenden Trägerelement, hinein vermittels eines anisotropen Ätzvorgangs hergestellt werden. Hierdurch werden ideal glatte Reflektionsflächen für die Lichtwegkorrektureinrichtung geschaffen. Eine Erhöhung des Wirkungsgrades von lichtemittierenden Halbleiterbauelementen ist somit in verschiedenen Bauformen möglich und eine Erhöhung der Lichtausbeute durch Nutzung der Seitenemission wird erreicht.

Ein vorteilhafter Verfahrensschritt sieht vor, dass wenigstens die die Lichtwegkorrektureinrichtung bildenden Oberflächen des kristallinen Materials insbesondere durch Bedampfen oder Sputtern mit einer Reflektionsschicht insbesondere aus Metall oder einem Dielektrikum überzogen wird. Durch die Beschichtung der Oberfläche wird eine Verbesserung der Reflektionseigenschaften gewährleistet.

Weitere Vorteile, Besonderheiten und zweckmäßige Weiterbildungen der Erfindung ergeben sich aus den weiteren Unteransprüchen.

Nachfolgend wird die Erfindung anhand der Zeichnung weiter erläutert. Im Einzelnen zeigen die schematischen Darstellungen in:
- Figur 1: eine schematische Querschnitts-Darstellung eines bevorzugten Ausführungsbeispieles eines erfindungs- gemäßen lichtemittierenden Halbleiterbauelements mit einer in einem kristallinen Trägerelement aus- gebildeten Lichtwegkorrektureinrichtung und einem aktiven Halbleiterelement; und
- Figur 2: eine Aufsicht auf das bevorzugte Ausführungsbei- spiel eines erfindungsgemäßen lichtemittierenden Halbleiterbauelements aus Figur 1.

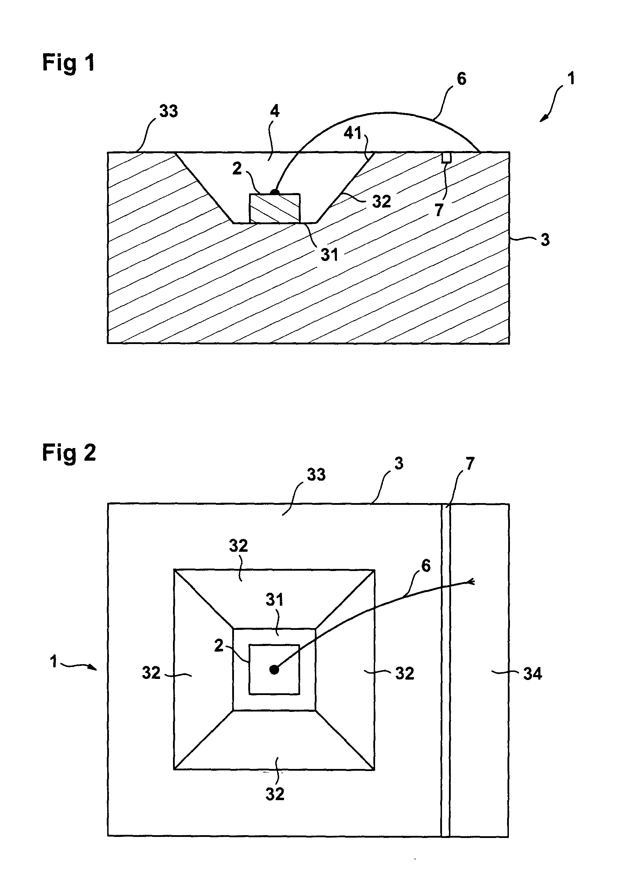

In den Figuren 1 und 2 ist ein erfindungsgemäßes lichtemittierendes Halbleiterbauelement 1 dargestellt. Die Bezugszeichen der Figuren 1 und 2 gelten hierbei analog.

Figur 1 zeigt einen Querschnitt durch ein erfindungsgemäßes lichtemittierendes Halbleiterbauelement 1. Das Halbleiterbauelement setzt sich hierbei aus einem Trägerelement 3, einem auf der Montage-Oberfläche 31 des Trägerelements 3 befestigten lichterzeugenden Halbleiterelement 2 (im Beispiel eine lichtemittierende Diode) und einer Lichtwegkorrektureinrichtung 41 in Form von Reflektionsflächen 32 zusammen. Das lichtaussendende aktive Halbleiterelement 2 ist in einer Vertiefung 4, die in die Oberfläche 33 des Trägerelements 3 eingebracht ist, auf der Montage-Oberfläche 31 des Trägerelements 3 befestigt, so dass das seitlich vom Halbleiterelement 2 emittierte Licht durch die die Lichtwegkorrektureinrichtung 41 bildende Reflektionsflächen 32 in die gewünschte Abstrahlrichtung gelenkt wird.

Zur Kontaktierung des aktiven Halbleiterelements 2 kann die Oberfläche der Montageoberfläche 31 metallisiert sein, wobei die Metallisierungsschicht gegen das Trägerelement 3 elektrisch durch eine Isolationsschicht (beispielsweise aus Siliziumdioxid) isoliert sein kann. Die Kontaktierungsschicht kann hierbei gleichzeitig eine auf den Reflektionsflächen aufgebrachte Metallisierung sein, die zur Erhöhung der Reflexivität eingesetzt wird. Eine zweite Kontaktierung des aktiven Halbleiterelements erfolgt durch eine an der dem Trägerelement abgewandten Oberfläche des Halbleiterelements 2 angebrachte Stromzuführung 6 in Form eines Bond-Drahtes. Der Bond-Draht wiederum kann auf der metallisierten Oberfläche 34 des Trägerelements 3 elektrisch verbunden sein. Die metallisierten Oberflächen 33 und 34 können hierbei nach der Metallisierung durch eine Fräsrille 7 in einfachster Weise elektrisch getrennt werden. Hierdurch kann durch einen einheitlichen Metallisierungsprozess die Stromzuführung zum aktiven Halbleiterelement durch die auf der Montageoberfläche 31, die Reflektionsschichten zur Erhöhung der Reflexivität auf den Reflektionsflächen 32 und eine großflächige kontaktierbare Stromanschlussflächen 33 und 34 geschaffen werden. Die Fräsrille 7 kann auch durch einen Säge- oder Lithographieprozess in das Substrat eingebracht werden.

Die Herstellung und Bestückung der Trägerelemente kann im Waferverbund (also vor deren Vereinzelung) erfolgen, was eine besonders effektive und billige Fertigung ermöglicht. Durch die anisotrope Ätzung der Vertiefung 4 und damit der Montage-oberfläche 31 und der Reflektionsflächen 32 werden besonders glatte und somit effektive Reflektions- beziehungsweise Montageflächen hergestellt, wodurch die Lichtausbeute erhöht wird. Zusätzlich wird die Ausfallquote der damit erzeugten lichtemittierenden Halbleiterbauelemente gesenkt, da der Ausdehnungskoeffizient der verwendeten Materialien für das aktive Halbleiterelement und das Trägerelement ähnlich ist.

## Patentansprüche

1. Lichtemittierendes Halbleiterbauelement (1) mit einem lichterzeugenden oder empfangenden aktiven Halbleiterelement (2), bei dem das auszusendende oder zu empfangende Lichtbündel durch eine Lichtwegkorrektureinrichtung (41) geformt ist, wobei das aktive Halbleiterelement auf der Montage-Oberfläche (31) eines dasselbe abstützenden Trägerelements (3) befestigt ist,
**dadurch gekennzeichnet,**
**dass** das Trägerelement (3) aus einem kristallinen Material besteht und die Lichtwegkorrektureinrichtung (41) durch Oberflächen (32) des Trägerelements (3) selbst gebildet ist.

2. Lichtemittierendes Halbleiterbauelement nach Anspruch 1,
**dadurch gekennzeichnet,**
**dass** die Lichtwegkorrektureinrichtung (41) ein die emittierten Lichtstrahlen reflektierende und bündelnde Reflektoreinrichtung ist.

3. Lichtemittierendes Halbleiterbauelement nach Anspruch 1 oder 2,
**dadurch gekennzeichnet,**
**dass** das Trägerelement eine Vertiefung (4) aufweist, dessen untere Begrenzungsfläche die Montage-Oberfläche (31) bildet.

4. Lichtemittierendes Halbleiterbauelement nach einem der Ansprüche 1 bis 3,
**dadurch gekennzeichnet,**
**dass** das Trägerelement (3) eine Vertiefung (4) aufweist, dessen seitliche Begrenzungsfläche(n) (32) die Lichtwegkorrektureinrichtung (41) bilden.

5. Lichtemittierendes Halbleiterbauelement nach einem der Ansprüche 1 bis 4,
**dadurch gekennzeichnet,**
**dass** wenigstens die die Lichtwegkorrektureinrichtung (41) bildenden Oberflächen (31, 32, 33) des Trägerelements (3) mit einer Reflektionsschicht überzogen sind.

6. Lichtemittierendes Halbleiterbauelement nach Anspruch 5,
**dadurch gekennzeichnet,**
**dass** die Reflektionsschicht durch eine Metall-Schicht oder durch eine dielektrische Schichtfolge ausgebildet ist.

7. Lichtemittierendes Halbleiterbauelement nach Anspruch 5 oder 6,
**dadurch gekennzeichnet,**
**dass** zwischen der Oberfläche des Trägerelements (3) und der Reflektionsschicht eine Isolationsschicht ausgebildet ist.

8. Lichtemittierendes Halbleiterbauelement nach einem der Ansprüche 5 bis 7,
**dadurch gekennzeichnet,**
**dass** die Reflektionsschicht eine der Stromzuführungen zum lichterzeugenden oder empfangenden aktiven Halbleiterelement (2) ist.

9. Verfahren zur Herstellung eines lichtemittierenden Bauelements mit einem aktiven Halbleiterelement (2) und einer Lichtwegkorrektureinrichtung (41) insbesondere nach einem der Ansprüche 1 bis 8,
**dadurch gekennzeichnet,**
**dass** die die Lichtwegkorrektureinrichtung (41) für das emittierte bzw. zu empfangende Licht eines aktiven Halbleiterelement bildenden Oberflächen (32) in ein kristallines Material, insbesondere in den das aktiven Halbleiterelements tragenden Trägerelement (3), hinein vermittels eines anisotropen Ätzvorgangs hergestellt werden.

10. Verfahren nach Anspruch 9,
**dadurch gekennzeichnet,**
**dass** wenigstens die die Lichtwegkorrektureinrichtung (41) bildenden Oberflächen (32) des kristallinen Materials insbesondere durch Bedampfen oder Sputtern mit einer Reflektionsschicht insbesondere aus Metall oder einem Dielektrikum überzogen wird.

11. Verfahren nach Anspruch 9 oder 10,
**dadurch gekennzeichnet,**
**dass** das aktive Halbleiterelement (2) mit dem Trägerelement (3) elektrisch leitend verbunden wird.

12. Verfahren nach Anspruch 9 bis 11,
**dadurch gekennzeichnet,**
**dass** das aktive Halbleiterelement (2) mit einer Leiterbahn auf dem Trägerelement (3) elektrisch verbunden wird, wobei das Trägerelement vom Halbleiterelement elektrisch isoliert ist.
